# EUROPÄISCHE PATENTSCHRIFT

(11) **EP 2 315 042 B1**
(45) Veröffentlichungstag und Bekanntmachung des Hinweises auf die Patenterteilung: **04.04.2018**
(21) Anmeldenummer: 10013750.4
(22) Anmeldetag: 19.10.2010
(51) Int. Cl.: G01R 27/16, G01R 33/12, H01F 6/02, H02H 7/00

(54) **Verfahren und Vorrichtung zur indirekten Überwachung eines elektrischen Leitwertes**
Method and device for indirect monitoring of an electric conductance
Procédé et dispositif destinés à la surveillance indirecte d'une valeur de courant électrique

(30) Priorität: 20.10.2009 DE 102009049859
(43) Veröffentlichungstag der Anmeldung: 27.04.2011
(73) Patentinhaber: Karlsruher Institut für Technologie, 76131 Karlsruhe (DE)
(72) Erfinder: Petry, Klaus, Dr., 76351 Linkenheim-Hochstetten (DE); Tcherniakhovski, Denis, 76133 Karlsruhe (DE); Ebersoldt, Andreas, 76870 Kandel (DE)

(56) Entgegenhaltungen:
- DE-A1- 2 839 787
- JP-A- 7 174 803
- JP-A- 8 075 810
- JP-A- 9 199 315
- BIRUS ET AL: "Development of Quench Detection System for W7-X", FUSION ENGINEERING AND DESIGN, ELSEVIER SCIENCE PUBLISHERS, AMSTERDAM, NL, Bd. 82, Nr. 5-14, 1. Oktober 2007 (2007-10-01), Seiten 1400-1405, XP022290954, ISSN: 0920-3796, DOI: DOI:10.1016/J.FUSENGDES.2007.04.054

## Beschreibung

Die Erfindung betrifft ein Verfahren sowie eine Vorrichtung zur indirekten Überwachung eines elektrischen Leitwertes gemäß der Ansprüche 1 und 10.

In elektrisch leitenden oder supraleitenden Systemen, die große Ströme im kilo-Ampere-Bereich übertragen, besitzt die Überwachung der elektrischen Leitfähigkeit in einem stromführenden Betrieb eine besondere sicherheitsrelevante Bedeutung. Eine lokale Verringerung des Leitwertes (G = 1/R) einer strom- oder konstantstromübertragenden Strecke, kann - vergleichbar mit dem schwächsten Glied in einer Kette - zur sofortigen Erwärmung und damit lokalen thermischen Zerstörung des Leiters führen. Die Zerstörung des Hochstromleiters im Betrieb kann unmittelbare Folgeschäden des gesamten elektrischen und mechanischen Systems nach sich ziehen (durch Hochspannungsüber- bzw. -durchschläge aufgrund der Selbstinduktion oder z.B. Schäden durch mechanische Kraftwechseleinwirkungen aufgrund zusammenbrechender Magnetfelder).

Beispielhaft für die vorgenannten Hochstromsysteme, werden elektrische Hochleistungs-Magnetspulen genannt, wie sie in Beschleunigern (z.B. LHC - Large Hadron Collider/Cern) oder in zukünftigen Fusionsreaktoren (z.B. Wendelstein 7-X, ITER) vorgesehen sind. Die Magnetfelder dienen hierbei dem Einschluss und der Ausformung des Plasmas. Als Leitermaterial für derartige Magnetspulen und deren Stromzuführungen dienen aufgrund der damit realisierbaren verlustfreien Stromübertragung bevorzugt Supraleiter.

Supraleiter müssen jedoch zur Erlangung der supraleitenden Eigenschaft durch spezielle Kryostaten auf Temperaturen unterhalb der sog. Sprungtemperatur abgekühlt werden. Für bestimmte Supraleiter liegt dieser Wert nahe dem absoluten Nullpunkt, z.B. zwischen 3 und 6 Kelvin.

Übersteigt die Leitertemperatur (z.B. aufgrund mangelhafter Kryoleistung) die spezifische Sprungtemperatur, verliert der Supraleiter seine supraleitende Eigenschaft. Der Übergang vom supraleitenden Zustand zu dem elektrisch normal leitenden, d.h. verlustbehafteten ohmschen Verhalten wird als Quench bezeichnet. Eine rechtzeitige und zuverlässige Quenchdetektion ist eine primäre Voraussetzung für einen wirksamen Schutz eines auf Supraleitern basierenden elektrischen Systems.

Eine Leitwertmessung zur Quenchdetektion erfolgt üblicherweise indirekt durch die messtechnische Erfassung der über dem Leiter abfallenden Spannung U. Bei bekanntem Strom lässt sich nach Anwendung des ohmschen Gesetzes dann der Leitwert errechnen (R = U/I; Leitwert G = 1/R = I/U). Je früher eine Verringerung des Leitwertes detektierbar ist, d.h. je niedriger eine im Detektionssystem (z.B. Spannungskomparator) einstellbare Vergleichsschwelle für den am Leiter messtechnisch erfassten Spannungsabfall gesetzt werden kann, desto früher kann der Betriebsstrom des Systems gezielt verringert, begrenzt oder abgeschaltet werden und die im Magnetfeld gespeicherte Energie kontrolliert entladen werden.

Eine möglichst niedrig einstellbare Vergleichsschwelle besitzt daher eine zentrale Bedeutung für einen schnellstmöglichen und damit effektiven Schutz des Leitersystems. Eine Verringerung des Leitwertes sollte jedoch nicht nur schnell, sondern auch zuverlässig erkannt werden. Fehlauslösungen führen zur unnötigen Schnellabschaltung des Stromkreises und neben der hiermit einhergehenden umfassenden Betriebsunterbrechung zu einer unnötigen elektrischen und mechanischen Belastung des supraleitenden Magnetsystems (durch Entladung der im Magnetfeld gespeicherten Energie).

Ein für potenzielle Fehlauslösungen kritischer Betriebszustand liegt im Anfahren oder Herunterfahren d.h. dem sog. Rampen des Hochstromsystems vor.

Unter Rampen versteht man den mit dem Anfahren des Systems verbundenen gesteuerten Stromanstieg und den mit dem Herunterfahren des Systems verbundenen gesteuerten Stromabfall. Ein Maximalstrom von beispielsweise 50kA wird nicht sofort auf den Leiter eingeprägt, sondern kontinuierlich oder in Stufen erhöht (z.B. mit einer zeitlichen Stromänderung di/dt von 50A/s). Ebenso wird bei der Entladung von Spulen der Strom kontinuierlich oder in Stufen erniedrigt.

Durch die zeitliche Stromänderung entsteht nach dem Selbstinduktionsgesetz (U_{ind} = -L·di/dt) über dem Leiter eine Spannung, die zunächst nicht von einem Spannungsabfall infolge eines Quenches unterschieden werden kann. Die Selbstinduktion stellt deshalb ein zentrales Problem für eine Quench-Detektion während des Rampens dar.

Um dieses Problem einzuschränken, wird üblicherweise ein Spannungsdifferenz-Meßprinzip angewandt. Hierzu wird der Spannungsabfall von zwei hintereinander (in Reihe) geschalteten Leiterabschnitten jeweils separat ermittelt. Da über die in Reihe geschalteten Leiterabschnitte derselbe Strom fließt, kann eine an beiden Leiterabschnitten durch Induktion entstehende Spannung durch eine entsprechende Messanordnung kompensiert werden. Der Gefahr, dass ein in beiden Leitern gleichzeitig und in gleichartiger Ausformung auftretender Quench durch Differenzbildung der einzelnen Messspannungen nicht registriert wird, lässt sich durch entsprechende Kaskadierung der Leiterabschnitte entgegenwirken. Hierzu werden mehrere in Reihe geschaltete Leiterabschnitte zu einem Abschnitt zusammengefasst und mit dem nächsten in Reihe liegenden Abschnitt in Differenzschaltung gebracht.

In **Brius et al.: Development of Quench Detection Systems for W7-X, XP022290954** wird beispielhaft ein Quench-Detektor mit einer einfachen programmierbaren Halbbrücke offenbart. Sie ermöglicht eine Einstellung des Verhältnisses der an zwei Messpunkten auf einem elektrischen Leiter abgegriffenen Potentialunterschiede jeweils zu einem dazwischen abgegriffenen Referenzsignal zwischen 0% und 100% aber nur in eine Richtung.

Ferner offenbart DE 28 39 787 A eine weitere Schaltung zur Quench-Detektion, bei der eine Asymmetrie mittels einstellbaren Widerstand nur in einem Brückenzweig korrigierbar ist.

Eine Differenzbildung eines Leiterabschnittes mit mehreren, in Serie liegenden und zusammengefassten Leiterabschnitten ist jedoch nur sinnvoll, wenn die Selbstinduktionsspannung des Einzelabschnittes gegenüber der oft zwangsläufig größeren Summe der Selbstinduktionsspannungen der nachfolgenden und zusammengefassten Abschnitte auch gegeneinander gewichtet, d.h. ausbalanciert werden kann. Durch bestmögliche Ausbalancierung ist es erst möglich, die Selbstinduktionsspannungen nahezu vollständig zu kompensieren und die Vergleichsschwelle eines Spannungskomparators (= Schaltschwelle des Detektors) entsprechend niedrig anzusetzen.

Die Ausbalancierung der Differenzeingänge wird allgemein dadurch erschwert, dass die Differenzeingänge gegenüber ihrem gemeinsamen Mittelpunkt (Bezugspunkt) hohen Spannungen bis zu einem Potential von ca. 500V (1000V Eingang zu Eingang) ausgesetzt sind, während die zu messenden Differenzspannungspotenziale üblicherweise unter 1000mV liegen.

Eine weitere Erschwernis bei der Leitwertmessung von supraleitenden Spulensystemen entsteht durch die erforderliche magnetische Verträglichkeit, die die Detektorelektronik gegenüber starken magnetischen Flussdichten (bis ca. 30mT) aufweisen muss. Aufgrund anzustrebender kurzer Leitungswege von Detektor zum Supraleiter wird die Detektorelektronik üblicherweise in räumlicher Nähe zum Spulensystem angeordnet und damit dem erzeugten Magnetfeld ausgesetzt.

Die zeitliche Erfassung der Leitwertüberschreitungs-Ereignisse (Quenchereignisse) in einem Multi-Detektorsystem (z.B. Gruppe mit 128 Detektoren) erfolgt üblicherweise mit Multikanal-Echtzeiterfassungssystemen (z.B. VME-Bus-System). Bei Einsatz eines derartigen Multikanalsystems ist jeder Detektorausgang (Ausgangssignal des Komparators) mit einem separaten Eingang des Erfassungssystems verbunden. Ein Flankenwechsel des Detektorausgangssignals wird hierbei vom Echtzeiterfassungssystem registriert und ein korrespondierender Zeitstempel generiert. Nachteilig erweist sich hier, dass bei derartigen Systemen für jeden Detektor eine separate Signalleitung und ein separater Eingang am Erfassungssystem erforderlich ist. Die notwendige Potenzialtrennung der Signale, der entstehende Verkabelungsaufwand und die große Anzahl der nötigen Signaleingänge am Erfassungssystem verursachen hohe Kosten.

Davon ausgehend liegt die **Aufgabe der Erfindung** nun darin, eine Vorrichtung und ein Verfahren zur zeitnahen Überwachung eines elektrischen Leitwertes im laufenden und stromführenden Betrieb von elektrischen Leitern aufzuzeigen, welche die vorgenannten Einschränkungen des Stands der Technik nicht aufweist. Insbesondere sollen schon geringste Leitwertänderungen eines stromdurchflossenen Supra- oder Normalleiters auf einem hohen Spannungsniveau, d.h. mit hoher Potenzialtrennung gegen Erdpotenzial sicher detektiert werden können und Leitwertüberschreitungsereignisse in einem Multidetektorsystem bzw. in einer Detektorgruppe kostengünstig mit geringstem Aufwand an Verkabelung und Rechnerhardware und dennoch zuverlässig und mit ausreichender zeitlicher Auflösung registriert werden.

Eine weitere Aufgabe liegt in der funktionellen Selbstüberwachung des Systems. Dabei soll sowohl die Detektorhardware als auch der eigentliche Messsignalanschluss überwacht werden.

Die Aufgabe wird mit einem Verfahren und einer Vorrichtung gemäß den Ansprüchen 1 und 10 gelöst. Die auf diese rückbezogenen Unteransprüche geben vorteilhafte Ausgestaltungen wieder.

Die Erfindung beinhaltet ein alternatives Quenchereignis-Erfassungsverfahren sowie eine Vorrichtung hierfür, wobei nur noch eine Signalleitung pro Multi-Detektorsystemeinheit benötigt und zusätzlich auf ein deterministisches Rechnersystem (Rechnersystem mit definierten Zykluszeiten, Echtzeit-, bzw. Real-Time-Erfassungssystem) verzichtet wird. Bei der der Erfindung zugrunde liegenden Vorrichtung werden dabei alle Detektorausgänge (potentialgetrennte Ausgänge eines Spannungskomparators im Detektor) innerhalb eines Multidetektorsystems verodert und nur das veroderte Signal einem Rechner (PC mit Interrupteingang) und/oder einer Capture-Karte (z.B. GPS-Uhrkarte mit Ereigniseingang (Triggereingang)) zugeführt.

Der Rechner oder die Karte speichert den Zeitpunkt eines Flankenwechsels dieses veroderten Signals.

Der Detektor selbst besitzt erfindungsgemäß einen Umlaufspeicher (Ringspeicher, Puffer) der kontinuierlich mit den ADC-Werten (digitalisierte Spannungswerte) der am Detektoreingang anliegenden Differenzspannung beschrieben wird (z.B. Speicher für 10 Sekunden bei einer Samplingrate von 100Ks/sec) und von seiner Worttiefe größer ausgelegt ist, als die gesampelten ADC-Abtastwerte (z.B. 16-Bit-Speicher, 12 Bit ADC-Werte). Im Falle eines Quench (Erreichen bzw. Überschreiten einer festgelegten Schwelle) erfolgt durch die detektorinterne Steuereinheit erfindungsgemäß unmittelbar ein zusätzlicher Eintrag in das gerade mit dem aktuellen ADC-Wert beschriebene Speicherstelle. Der Eintrag erfolgt durch Setzen eines freien Bits, z.B. Bit 15. Das gesetzte Bit wird dabei als interne Quenchkennung bezeichnet. Ein weiterer Eintrag einer internen Quenchkennung erfolgt in einem Statusregister des Detektors. Gleichzeitig wird erfindungsgemäß aufgrund der hardwareseitigen Veroderung der Detektorausgangssignale dieses erste Ereignis vom übergeordneten Rechner (Interrupteingang oder Capture-Karte) registriert und mit einem Zeitstempel versehen (Zeitpunkt des ersten Quenchereignisses).

Der an das Detektorsystem angeschlossene Rechner führt erfindungsgemäß eine sequentielle Abfrage aller in einer Gruppe vorhandenen Detektoren durch (z.B. über einen Voll-Duplex RS485-Bus) und ermittelt, ob in einem oder mehreren Detektoren ein Quenchereignis aufgetreten ist (durch Auslesen eines Statusregisters im Detektor).

Der Umlaufspeicher im Detektor wird erfindungsgemäß im Falle eines Quenches für eine (einstellbare) Nachlaufzeit weiterhin mit den aktuellen ADC-Werten beschrieben bis der Schreibvorgang (nach Ende einer Nachlaufzeit, z.B. nach 5 Sekunden) automatisch gestoppt wird.

Wird vom übergeordneten Rechner nun ein Quenchereignis durch Auslesen der Detektorstati ermittelt, sendet der Rechner über die Kommunikationsschnittstelle erfindungsgemäß eine Mitteilung, die von allen in der Gruppe vorhandenen Detektoren gleichzeitig empfangen wird (sog. Broadcast-Mitteilung).

Durch diese gleichzeitig von allen Detektoren empfangene Broadcast-Mitteilung wird über die interne Steuereinheit des Detektors bei jedem Detektor ein weiterer Eintrag im gerade mit dem aktuellen ADC-Wert beschriebenen Speicherregister vorgenommen. Der Eintrag erfolgt durch Setzen eines anderen freien Bits, z.B. Bit 14. Dieses gesetzte Bit wird dabei als externe Quenchkennung bezeichnet und dient erfindungsgemäß einer eindeutigen Synchronisation der Verlaufsspeicher aller angeschlossenen Detektoren.

Der Umlaufspeicher wird nun im Falle der externen Quench-Mitteilung erfindungsgemäß ebenfalls für eine (einstellbare) Nachlaufzeit weiterhin mit den aktuellen ADC-Werten inklusive der externen Quenchkennung beschrieben bis der Schreibvorgang (nach Ende der Nachlaufzeit, z.B. nach 5 Sekunden) automatisch gestoppt wird.

Nach diesem Vorgang sind im Umlaufspeicher aller in der Gruppe vorhandenen Detektoren folgende Informationen vorhanden (Bit-Deklaration ist beispielhaft gewählt, z.B. Bit 0 - 11 ADC-Werte):

### 1. Detektor, der einen Quench erkannte:

- Bit 15 zuerst gesetzt: internes Quenchereignis, vom Detektor selbst registriert
- Bit 14 danach gesetzt: externe Quench-Mitteilung, vom an-geschlossenen Rechner mitgeteilt

### 2. Übrige Detektoren (Variante A, kein weiterer Quench aufgetreten)

- Bit 15 nicht gesetzt: kein internes Quenchereignis aufgetreten
- Bit 14 gesetzt: externe Quench-Mitteilung, vom angeschlossenen Rechner mitgeteilt

### 3. Übrige Detektoren (Variante B, weiterer Quench aufgetreten)

- Bit 14 gesetzt: externe Quench-Mitteilung, vom angeschlossenen Rechner mitgeteilt
- Bit 15 gesetzt: internes Quenchereignis, vom Detektor selbst registriert. Das interne Quenchereignis kann nun vor, gleichzeitig mit, oder nach der externen Quench-Mitteilung aufgetreten sein.

Nach Ende der Nachlaufzeit werden erfindungsgemäß alle Umlaufspeicher vom Rechner ausgelesen und aufgrund der jeweiligen Lage der internen Quenchkennung (internes Quenchflag z.B. Bit 15) gegenüber dem externen Quenchflag (z.B. Bit 14), das als Synchronisationsflag dient, alle Quenchereignisse eindeutig bestimmt und eine exakte zeitliche Abfolge der Ereignisse errechnet.

Erfindungsgemäß ist diese Berechnung eindeutig möglich, weil das erste Ereignis aufgrund der hardwareseitigen Veroderung zeitlich direkt bestimmt wird (Interrupteingang oder Capture-Karte des angeschlossenen Rechners) und aufgrund der Lage der internen und externen Quenchkennungen im Verlaufsspeicher und der bekannten Samplingrate alle Zeitpunkte weiterer Ereignisse innerhalb der Nachlaufzeit rekonstruiert werden können.

**Tab.1** zeigt eine beispielhafte Kennung von internem und externem Quenchereignis im Umlaufspeicher zusammen mit den ADC-Werten der Differenzspannung und einem Bit, über welches eine veränderbare Samplingrate codiert wird.

Durch das beschriebene Verfahren wird der Einsatz eines aufwendigen separaten Echtzeiterfassungssystems zur Quench-Ereignisverfolgung obsolet, und damit das ganze Detektorsystem einschließlich Ereignisverfolgung wesentlich vereinfacht. Ebenfalls wird kein determinitisches Rechnersystem benötigt, da die indirekte Synchronisation (über die als Broadcast an alle Detektoren gleichzeitig gesendete externe Quenchmitteilung) zwar innerhalb der Nachlaufzeit erfolgen muss, ein definierter Zeitpunkt hierfür jedoch nicht vorausgesetzt werden muss.

**Tab.1: Kennung der Quench-Ereignisse im Umlaufspeicher (Auszug)**

| Bit | SX | SX+1 | SX+2 | SX+3 | SX+4 | SX+5 | SX+6 | SX+N |
|---|---|---|---|---|---|---|---|---|
| 0 | x | | x | x | | | | |
| 1 | | | | | | | | |
| 2 | | x | x | | | | | |
| 3 | | | | | | | | |
| 4 | | | x | | | | | |
| 5 | | | | | | | | |
| 6 | | | x | | | | | |
| 7 | | | | x | | | | |
| 8 | | | | | | | | |
| 9 | | | | | | | | |
| 10 | | | | x | | | | |
| 11 | | | | | | | | |
| 12 | CSR | CSR | CSR | CSR | CSR | CSR | CSR | CSR |
| 13 | | | | | | | | |
| 14 | | | | | | E | E | E |
| 15 | | | | I | I | I | I | I |

| | | | | | | | | |
|---|---|---|---|---|---|---|---|---|
| Legende: SX = Speicherzelle X x = ADC-Wert der Differenzspannung (Bit 0 - Bit 11) CSR = Codierung Samplinrate (Bit 12) E = Externe Quenchkennung (Bit 14) I = Interne Quenchkennung (Bit 15) | | | | | | | | |

Weitere Vorteile ergeben sich aus der Tatsache, dass die indirekte Synchronisation erfindungsgemäß erst mit dem eigentlichen Ereignis ausgelöst wird und damit ein bestmöglicher Gleichlauf gewährleistet wird. Der Detektor selbst benötigt zudem keine zusätzliche RTC-Unit (Real-Time-Clock), da der ADC-Samplingtakt, der wiederum von einer Quarzbasis von der Steuereinheit abgeleitet wird, in diesem Verfahren als RTC-Basis dient.

Die Erfindung umfasst folglich ein Verfahren sowie eine Vorrichtung zur Überwachung eines elektrischen Leitwertes in einem Strom führenden elektrischen Leiter mit mindestens einer Differenzspannungsmessbrücke, wobei jeweils zwei Eingangssignale U_{Pos} und U_{Neg} über jeweils einen von zwei in Reihe geschalteten Leiterabschnitten des elektrischen Leiters separat gegen ein gemeinsames Referenzsignal geschaltet sind. Die Potentialunterschiede zwischen U_{Pos} bzw. U_{Neg} jeweils zum Referenzsignal werden von der Vorrichtung aufgenommen und beeinflusst von einer Steuereinheit zu einem Ausgangssignal weiterverarbeitet.

Wesentlich ist, dass das Verhältnis der Potentialunterschiede von U_{Pos} und U_{Neg} oder umgekehrt jeweils zum Referenzsignal zwischen 0% und 100% kontinuierlich einstellbar ist. Diese Einstellung erfolgt über ein Doppelpotentiometer-Balancierungsnetzwerk, wobei die Einstellung von einer Steuereinheit digital vorgegeben wird.

Damit wird eine Balancierung von U_{Pos} (+) zu U_{Neg} (-) oder umgekehrt in beliebigem Verhältnis von 0% bis 100% erreichbar, wobei die Stellung 100% die vollständige Einblendung und die Stellung 0% die vollständige Ausblendung der jeweiligen Eingangssignale darstellt. Auch hat ein auf 0% reduziertes Eingangssignal auf das nachfolgend gebildete Differenzsignal keinen Einfluss.

Bei der Weiterverarbeitung wird das Differenzsignal jeweils separaten redundanten Verstärkern zur Verstärkung des Potenzialunterschieds zugeleitet. Dabei wird in einer weiteren bevorzugten Ausführung mindestens eines der verstärkten Signale über ein Antialiasingfilter und einen AD-Wandler einer Steuereinheit zugeleitet, welche die digitalisierten Differenzspannungswerte beeinflusst oder unbeeinflusst einem Umlaufspeicher zuführt. Die Steuereinheit dient der Einstellung von Verstärkern zur Signalverstärkung, der Ansteuerung von Signalmultiplexern zur Differenzsignalweiterführung oder Aufschaltung von Testsignalen, der Einstellung von RC-Filtern zur Signalkonditionierung und zur Einstellung von Doppelkomparatoren, welche als bipolare Differenzspannungs-Schwellwertschalter eingesetzt werden. Deren Ausgangssignale werden wiederum über einen von der Steuereinheit einstellbaren Schalter zugeführt, der eine Selektion oder Veroderung der bipolaren Komparatorausgänge vornehmen kann.

Bekanntermaßen besitzen Selbstinduktionsspannungen gegen einer am Messleiter angelegten Spannung umgekehrte Polarität (U=-L·x·di/dt). Durch die gezielte polaritätssensitive Unterdrückung dieser Spannungen, d.h. gezielte Selektion, welcher der bipolaren Komparatorausgänge den Detektorausgang-bildet, kann mit der Erfindung die Detektionssicherheit nochmals gesteigert werden (Steigerung des Nutz-/Störsignalverhältnisses).

Vorzugsweise durchlaufen die Signale die vorgenannten Komponenten in genannter Reihenfolge. Die gesamte Detektoreinheit ist dabei gegenüber Erdpotential optisch bzw. galvanisch getrennt ausgeführt.

Die Erfindung wird im Folgenden anhand von möglichen Ausführungsformen näher erläutert. Dabei zeigen
**Fig.1** ein Blockschaltbild der Vorrichtung zur indirekten Leitwertmessung,
**Fig.2** ein Schaltbild einer Eingangsüberspannungsschutzvorrichtung (Limiter) gem. **Fig.1** sowie
**Fig.3** eine Zusammenfassung einer Vielzahl von Vorrichtungen gem. **Fig.1** zu einem Quenchereigniserfassungssystem mittels nicht deterministischem Rechnersystem.

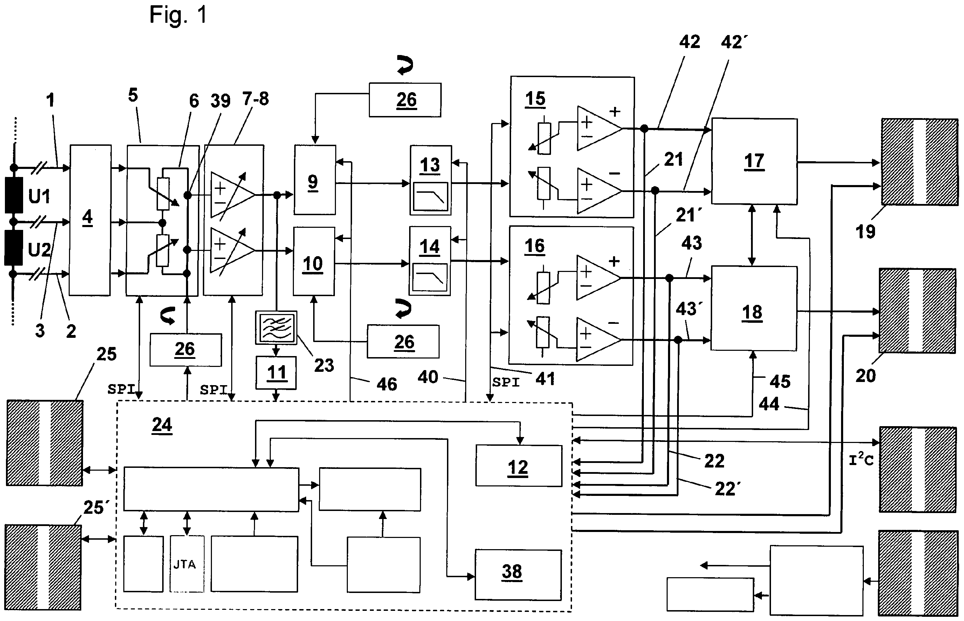

Die Vorrichtung (Detektor) gem. **Fig.1** umfasst eine Eingangsüberspannungsschutzvorrichtung (Limiter) **4** zur Begrenzung der Eingangssignale U_{Pos} **1** und U_{Neg} **2** über jeweils einen von zwei in Reihe geschalteten Leiterabschnitten (mit den Potenzialunterschieden **U1** und **U2** gekennzeichneten Widerständen) eines elektrischen Leiters sowie eines gemeinsamen Referenzsignals **3.** U_{Pos} **1** und U_{Neg} **2** sowie das Referenzsignal **3** werden anschließend an ein Balancierungsnetzwerk **5** mit einer Doppelpotentiometerschaltung weitergeleitet, in dem das Verhältnis der Potentialunterschiede von U_{Pos} und U_{Neg} oder umgekehrt jeweils zum Referenzsignal **3** zwischen 0% und 100% beliebig einstellbar ist. Die Doppelpotentiometerschaltung wird wiederum von einer Steuereinheit **24** vorzugsweise über ein Bussystem, z.B. SPI-Bus angesteuert.

Im Doppelpotentiometer-Balancierungsnetzwerk **5** wird aus den vorgenannten Potenzialunterschieden durch Zusammenführung ein Differenzsignal **6** generiert und an jeweils separate Verstärker **7** und **8** zur Signalverstärkung weitergeleitet. Dabei wird mindestens eines der verstärkten Signale über ein rückwirkungsfreies Antialiasingfilter **23** einem AD-Wandler **11** zur Abtastung und Digitalisierung zugeführt und die digitalisierten Signale anschließend der Steuereinheit **24** zugeleitet. Die Steuereinheit ermöglicht eine unmittelbare abtastsynchrone Beeinflussung der digitalisierten Werte (z.B. Verrechnung eines Offsets Veränderung der Abtastrate), eine zur Digitalisierung parallele zeitgleiche Einfügung von Kennungsbits in die Datenworte und eine Onlinespeicherung dieser Datenworte in einem an die Steuereinheit **24** angeschlossenen Umlaufspeicher **12.**

Die Konditionierung der verstärkten Signale umfasst die nachfolgend genannten Verfahrensschritte und erfolgt aus Redundanzgründen für jedes verstärkte Signal separat ohne gegenseitige Wechselwirkung.

Die Ausgangssignale der Verstärker **7, 8** werden jeweils separat je einem von der Steuereinheit **24** über ein Verstärkersteuersignal **46** gesteuerten und als Schalter dienenden Multiplexer **9, 10** zugeführt. Die Multiplexer **9, 10** ermöglichen sowohl eine Weiterleitung des verstärkten Signals als auch eine Aufschaltung von Testsignalen an die nachfolgenden Schaltungskomponenten zur Funktionskontrolle und Kalibration der Vorrichtung nach **Fig.1****.**

Die über die Multiplexer **9, 10** geleiteten Signale werden separat je einem digital über die Steuereinheit **24** über Filtersteuersignale **40** einstell- und ausschaltbaren jeweils unabhängigen, einstellbaren und getrennten Tiefpassfiltern **13, 14** zugeführt. Die Filter dienen vorzugsweise zur Unterdrückung von unerwünschten Signalanteilen des Stroms, mit denen die zu überwachenden Leiter beaufschlagt werden (z. B. zur Dämpfung von Oberwellen der Hochstromquelle).

Anschließend werden die Signale jeweils separaten voneinander unabhängigen über Komparatorsteuersignalen **41** einstellbaren Schwellwertschaltern (Komparatoren) **15, 16** zugeführt. Die Komparatoren sind vorzugsweise jeweils bipolar, d.h. als getrennter positiver und negativer Schwellwertschalter ausgeführt, wobei sich die positive und die negative Schwelle der Komparatoren separat von der Steuereinheit **24** digital einstellen lassen.

Die voneinander unabhängigen Ausgangssignale **42, 42', 43, 43'** der Komparatoren **15, 16** haben identische Ausgangslogikpegel (z.B. Low = Überschreitung einer positiven oder Unterschreitung einer negativen Schwelle) und werden separat einerseits über einen von der Steuereinheit **24** über Schaltersteuersignale **44, 45** beeinflussbaren, jedoch mit einer Failsafe-Logik versehenen elektronischen Schaltern **17, 18** als Quench-Ereignissignal dem Detektorausgang **19, 20** zugeführt (Detektorausgangssignal), und andererseits jeweils separat als Kontrollsignale **21, 21', 22** und **22'** (positive Komparatorausgangssignale **21, 22,** negative Komparatorausgangssignale **21', 22'**) der Steuereinheit **24** zugeleitet.

Der jeweils separate elektronische Schalter **17, 18** dient der selektiven Unterdrückung von einem der beiden Komparatorausgangssignale (mögliche Unterdrückung des positiven oder des negativen Komparatorausgangssignals, unipolarer Betrieb) oder alternativ einer Weiterschaltung einer Kombination von beiden Komparatorausgängen (Verodertes Ausgangssignal von negativem und positivem Komparatorsignal, bipolarer Betrieb) an die Detektorausgangsstufe **19** bzw. **20.** Beide Komparatorpaare **17** bzw. **18** sind vorzugsweise voneinander unabhängig und separat d.h. redundant ausgeführt. Die elektronischen Schalter besitzen vorzugsweise eine von der Steuereinheit **24** nicht beeinflussbare Failsafe-Logik, die im Falle einer Fehlsteuerung durch die Steuereinheit **24** (z.B. bei Unterdrückung beider Komparatorausgänge) dafür Sorge trägt, dass im Fehlerfalle aus Sicherheitsgründen dem Detektorausgang ein Zwangssignal zugeleitet wird (künstliche Erzeugung eines Quench-Ereignisses).

Der Logikpegel des Detektorausganges ist dabei vorzugsweise so ausgelegt, dass auch bei Fehlen der Detektorversorgungsspannungen (z.B. durch Netzteilfehler im Detektor) ein Zwangssignal am Detektorausgang anliegt (Quench- oder Fehlerzustandsanzeige über Aktiv-Low-Signal).

Aufgrund der Möglichkeit über die elektronischen Schalter **17, 18** das Ausgangssignal des positiven oder des negativen Komparators zu unterdrücken ist der Detektor neben der bipolaren Betriebsweise auch polaritätssensitiv einsetzbar, d.h. störende Selbstinduktionsspannungen mit umgekehrter Polarität im zu überwachenden Leiterabschnitt (z.B. in einer supraleitenden Spule) sind ausblendbar. Durch eine polaritätssensitive Unterdrückung dieser Spannungen steigert man das Verhältnis von Nutz- zu Störsignal und verbessert damit die Detektionssicherheit in vorteilhafter Weise erheblich.

Über die Multiplexer **9** und **10** sowie die Schalter **17** und **18** ist jeweils eine der beiden sich redundant zueinander verhaltenden Detektionsschaltungen für eine Funktionsüberprüfung mittels Testsignal von der Steuereinheit **24** freischaltbar (jeweils immer ein Polaritätszweig aufgrund der Failsafe-Logik in **17** und **18**). Vorzugweise leitet hierzu die Steuereinheit **24** eine positive und/oder negative Testspannung von einem Spannungssignalgeber **26** über den Multiplexer **9** oder **10** in das Tiefpass-Filter **13** bzw. **14** ein und empfängt das Testausgangssignal als Kontrollsignal **21, 21', 22** oder **22'.** Während der Testphase bleibt die jeweils andere Detektionsschaltung in die Gesamtschaltung eingebunden und ist damit für die Erfassung einer Leitwertverringerung weiterhin aktiv.

Eine Kalibrierung des Detektors selbst erfolgt über eine Justierung der Doppelpotentiometerschaltungen **5** und eine gegenseitige Anpassung der Verstärkung der Verstärker **7** bzw. **8.** Die Kalibrierung gewährleistet, dass aufgrund eines geringeren Unterschiedes zwischen einer am Detektoreingang und effektiv an den Schwellwertschaltern **15, 16** anliegenden Spannung und eines durch diese Angleichungsmöglichkeit zusätzlichen geringeren Unterschiedes der beiden redundanten Detektionsschaltungen untereinander eine geringere Schaltschwelle des Detektors einstellbar ist. Dies beschleunigt die eigentliche Leitwertmessung, womit in vorteilhafter Weise die Detektorreaktionszeit auf eine Leitwertabnahme signifikant reduzierbar ist.

Ferner lassen sich im Rahmen dieser Maßnahme Toleranzen der Eingangsüberspannungsschutzvorrichtung **4** ausgleichen, die aufgrund der notwendigen Strombelastbarkeit vorzugsweise mit Hochlastwiderständen realisiert wird, welche im Gegensatz zu Standardwiderständen (z.B. 1%-Widerstände) systembedingt erheblich höhere Toleranzen aufweisen (5-10%).

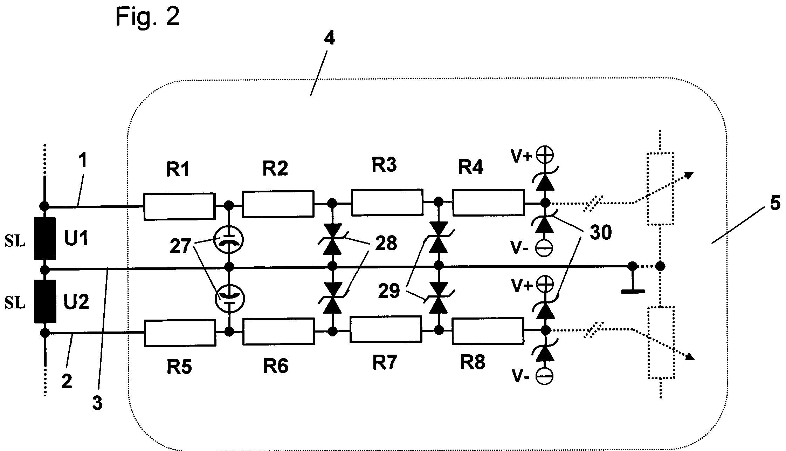

**Fig.2** zeigt die Verschaltung in der Eingangsüberspannungsschutzvorrichtung **4** mit Eingängen für die Eingangssignale U_{Pos} **1** und U_{Neg} **2**, die über eine Serienschaltung verschiedener Widerstände **R1** bis **R4** bzw. **R5** bis **R8** mit der nachfolgenden Doppelpotentiometerschaltung **5** verbunden sind. Die beiden Eingangssignale sind ferner über jeweils einen Arrester **27** (Ableiter), HS-Supressor-Dioden **28,** Zener-Dioden **29** mit dem Referenzsignal **3,** sowie je mit einer netzseitigen Ableitung **30** verbunden. In der Eingangsüberspannungsschutzvorrichtung nach **Fig.2** stellt jede Begrenzungsstufe ein für die jeweils nächste Stufe verträgliches Spannungspotenzial sicher. Die letzte Stufe sorgt für eine Detektornetzseitige bipolare Stromableitung und bewirkt damit, dass interne Schutzdioden in der Halbleiter-Doppelpotentiometerschaltung nicht überlastet werden. Zur Kompensation von Leckströmen der Dioden ist das ganze Begrenzungsnetzwerk nach **Fig.2** symmetrisch bipolar aufgebaut.

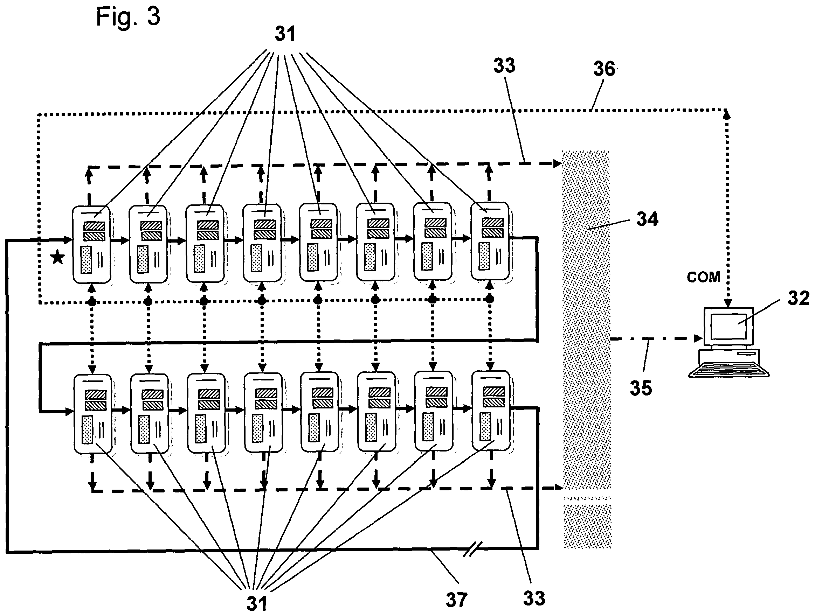

**Fig.3** zeigt die Verschaltung einer Vielzahl der vorgenannten Vorrichtungen **31** (Detektoren gemäß **Fig.1**) zu einem Detektorsystem mit zentralem Steuerungs- und Messdatenerfassungsrechner **32.** Die Ereigniserfassung aller Detektorereignisse erfolgt über physikalische Veroderung der Detektorausgänge **33** zur Erfassung des ersten Ereignisses und basierend hierauf anschließender indirekter Synchronisation der Umlaufspeicher aller Detektoren. Dabei werden die Detektorausgänge zu einer Bündelungseinheit **34** (Vorzugsweise z. B. auf einer Backplane der Detektorracks) geleitet, dort miteinander veroderte und das voroderte Signal **35** dem Rechner **32** zugeführt. Der Rechner oder eine Capture-Karte speichert den Zeitpunkt eines Flankenwechsels dieses veroderten Signals und synchronisiert anschließend durch eine sog. Broadcast-Mitteilung (Mitteilung, die von jedem am Bussystem angeschlossenen Detektor gleichzeitig erkannt und verarbeitet wird) über eine Master-Bus-Leitung **36** sowie einer vorrichtungsseitigen PC-Schnittstelle **25** (**Fig.1**) die Umlaufspeicher in den Vorrichtungen **31** (Detektoren) durch Setzen eines Kennungsbits. Eine zwischen den Vorrichtungen **31** als Ringsystem eingesetzte Slave-Bus-Leitung **37** dient der Sicherstellung einer Quittierung dieser Broadcast-Mitteilungen durch Weiterleitung einer Quittung bis zum ersten Detektor, welcher wiederum über die Master-Bus-Leitung **36** seinerseits quittiert.

Durch die vorgestellten Verfahren sowie die Vorrichtung (Detektor) wird eine signifikant erhöhte messtechnische Qualität der Online-Leitwertüberprüfung im stromführenden Betrieb ermöglicht. Ein Hauptproblem der sich widersprechenden Anforderung nach zuverlässiger Gross-Spannungsfestigkeit der Messeingänge (typischerweise im Bereich von 500V bis 2000V) und der gleichzeitig gewünschten sicheren Erfassung auch niedriger Schwellwertüberschreitungen bevorzugt unter 100 mV wird durch die vorgestellte Vorrichtung und die aufgeführten Verfahren, insbesondere durch die spezielle Balancierbarkeit der Eingänge und die Kalibrationsmöglichkeit der redundanten Detektionseinrichtungen ermöglicht.

Als Konsequenz ergibt sich ein schnellerer und damit wesentlich verbesserter Schutz eines mit Hochstrom-Supra- oder Normalleitern aufgebauten Magnet-Spulensystems unter den besonderen Bedingungen der notwendigen Potenzialtrennung und Resistenz gegenüber hohen magnetischen Flussdichten.

### Bezugszeichenliste:

- 1: Eingangssignal U_{Pos}
- 2: Eingangssignal U_{Neg}
- 3: Referenzsignal
- 4: Eingangsüberspannungsschutzvorrichtung (Limiter)
- 5: Doppelpotentiometer-Balancierungsnetzwerk
- 6: Differenzsignal
- 7: Verstärker für U_{Pos}
- 8: Verstärker für U_{Neg}
- 9: Multiplexer U_{Pos}
- 10: Multiplexer U_{Neg}
- 11: AD-Wandler
- 12: Umlaufspeicher der digitalisierten Differenzspannungswerte inklusive Kennungsbits
- 13: Tiefpass-Filter U_{Pos}
- 14: Tiefpass-Filter U_{Neg}
- 15: Schwellwertschalter U_{Pos}
- 16: Schwellwertschalter U_{Neg}
- 17: Schalter U_{Pos}
- 18: Schalter U_{Neg}
- 19: Detektorausgang U_{Pos}
- 20: Detektorausgang U_{Neg}
- 21, 21', 22, 22': Kontrollsignale
- 23: Antialiasingfilter
- 24: Steuereinheit
- 25: PC-Schnittstelle
- 26: Spannungssignalgeber
- 27: Arrester (Ableiter)
- 28: HS-Supressor-Diode
- 29: Zener-Diode
- 30: netzseitige Ableitung
- 31: Vorrichtung (Detektor)
- 32: Steuerungs- und Messdatenerfassungsrechner
- 33: Detektorausgänge
- 34: Bündelungseinheit
- 35: vorodertes Signal
- 36: Master-Bus-Leitung
- 37: Slave-Bus-Leitung
- 38: Festwertspeicher (EEPROM)
- 39: Knotenpunkt der Differenzbildung
- 40: Filtersteuersignale
- 41: Komparatorsteuersignale
- 42, 42', 43, 43': Kompatatorausgangssignale
- 44, 45: Schaltersteuersignale
- 46: Verstärkersteuersignal

## Patentansprüche

1. Verfahren zur Überwachung eines elektrischen Leitwertes in einem Strom führenden elektrischen Leiter mit einer Differenzspannungs-Messbrücke eines Detektors **(31),** wobei ein Eingangssignal U_{Pos} **(1)** und ein Eingangssignal U_{Neg} **(2)** von zwei in Reihe geschalteten Leiterabschnitten gegen ein gemeinsames Referenzsignal **(3)** geschaltet sind, wobei
a) das Verhältnis der Potentialunterschiede von U_{Pos} und U_{Neg} oder umgekehrt jeweils zum Referenzsignal zwischen 0% und 100% kontinuierlich einstellbar ist und damit eine beliebige Balancierung dieser Potentialunterschiede zueinander ermöglicht ist sowie
b) die Einstellung des Verhältnisses über ein Doppelpotentiometer-Balancierungsnetzwerk **(5)** erfolgt, wobei die Einstellung von einer Steuereinheit **(24)** digital vorgegeben wird und das Doppelpotentiometer-Balancierungsnetzwerk **(5)** ein Differenzsignal **(6)** auf einem Knotenpunkt **(39)** generiert.

2. Verfahren nach Anspruch 1, wobei die Steuereinheit **(24)** eine positive oder negative Testspannung **(26)** auswählt und zur Überprüfung einer korrekten Verschaltung und/oder Verbindung zwischen den Eingangssignalen **(1, 2, 3)** und dem Doppelpotentiometer-Balancierungsnetzwerk **(5)** auf den Knotenpunkt **(39)** aufschaltet.

3. Verfahren nach Anspruch 1 oder 2, wobei das Differenzsignal **(6)** aus einem ersten und einem zweiten Signal gebildet wird, die jeweils den Eingangssignalen **(1, 2)** zugeordnet werden und getrennt voneinander von je einem über die Steuereinheit **(24)** individuell einstellbaren Verstärker **(7, 8)** zu zwei separaten Differenzausgangssignalen verstärkt werden.

4. Verfahren nach Anspruch 3, wobei das Differenzausgangssignal eines der Verstärkers **(7, 8)** über ein Antialiasingfilter **(23)** geleitet von einem AD-Wandler **(11)** kontinuierlich abgetastet und über die Steuereinheit **(24)** in einem Umlaufspeicher **(12)** als ADC-Werte aufgezeichnet wird, wobei im Umlaufspeicher jeweils in einem Speicherwort zusätzlich zum ADC-Wert zeitgleiche, von der Steuereinheit **(24)** generierte Statusinformationen gesichert werden.

5. Verfahren nach einem der Ansprüche 3 oder 4, wobei bei einer vorgegebenen Betriebsstromrichtung in den Leiterabschnitten eine Berechnung des effektiv über jedem Leiterabschnitt jeweils abfallenden Spannungsabfalls erfolgt.

6. Verfahren nach einem der Ansprüche 3 bis 5, wobei die beiden Differenzausgangssignale jeweils separat in je einem Kanal
a) je einem Multiplexer **(9, 10)** zugeführt werden,
b) deren Ausgangssignale je einem von der Steuereinheit **(24)** unabhängigen, einstellbaren und ausschaltbaren Tiefpassfilter **(13, 14)** zugeführt werden,
c) deren Ausgangssignale anschließend je einem von der Steuereinheit **(24)** separat und voneinander unabhängig digital einstellbaren bipolaren Schwellwertschaltern **(15, 16)** zugeleitet werden,
d) deren Ausgangssignale jeweils separat einem weiteren, von der Steuereinheit **(24)** beeinflussten Schalter **(17, 18)** zugeführt werden, wobei entweder nur das positive, nur das negative oder beide Signale des Schwellwertschalters **(15 oder 16)** dem eigentlichen Detektorausgang **(19, 20)** zugeführt werden.

7. Verfahren nach Anspruch 6, wobei von beiden Kanälen zwischen den Schwellwertschaltern **(15,16)** und den Schaltern **(17, 18)** Kontrollsignale **(21, 21', 22, 22')** abgegriffen und zur Steuereinheit **(24)** zurückgeführt werden.

8. Verfahren nach Anspruch 7, umfassend eine Überprüfung der Multiplexer **(9, 10),** der Tiefpass-Filter **(13, 14)** sowie der Schwellwertschalter **(15, 16),** wobei
a) nur einer der redundant vorhandenen Kanäle am Multiplexer **(9 oder 10)** und am Schalter **(17 oder 18)** unterbrochen wird,
b) von der Steuereinheit **(24)** am Muliplexer ein Testsignal selektiert wird, welches anstelle eines Differenzausgangssignals an das Tiefpassfilter weitergeleitet wird,
c) mindestens ein Kontrollsignal **(21, 21', 22, 22')** aus dem Kanal zwischen Schwellwertschalter **(15, 16)** und Schalter **(17, 18)** abgegriffen und zur Steuereinheit **(24)** zurückgeführt werden sowie
d) in der Steuereinheit **(24)** die Kontrollsignale ausgewertet werden.

9. Verfahren nach Anspruch 8, wobei aufgrund des einstellbaren Doppelpotentiometer-Balancierungsnetzwerks **(5),** der separat für jeden Kanal von der Steuereinheit **(24)** einstellbaren Verstärker **(7, 8)** und der Zuleitung der Kontrollsignale **(21, 21', 22, 22')** zur Steuereinheit **(24)** eine Kalibration der zu detektierenden Eingangssignale **(1, 2)** gegenüber den einzustellenden Schwellwertschaltern **(15,16)** ermöglicht wird, wobei die Kalibrationsparameter in einem Festwertspeicher **(38)** gesichert werden.

10. Vorrichtung zur indirekten Überwachung eines elektrischen Leitwertes in einem Strom führenden elektrischen Leiter mit einer Differenzspannungs-Messbrücke eines Detektors **(31),** wobei ein Eingangssignal U_{Pos} **(1)** und ein Eingangssignal U_{Neg} **(2)** von zwei in Reihe geschalteten Leiterabschnitten gegen ein gemeinsames Referenzsignal **(3)** geschaltet sind, wobei
a) das Verhältnis der Potentialunterschiede von U_{Pos} und U_{Neg} oder umgekehrt jeweils zum Referenzsignal zwischen 0% und 100% kontinuierlich einstellbar ist und damit eine beliebige Balancierung dieser Potentialunterschiede zueinander ermöglicht wird sowie
b) ein Doppelpotentiometer-Balancierungsnetzwerk **(5)** zur Generierung eines Differenzsignals **(6)** für die Einstellung des Verhältnisses vorgesehen ist, wobei die Einstellung von einer Steuereinheit **(24)** digital vorgegeben wird.

11. Vorrichtung nach Anspruch 10, wobei das Differenzsignal **(6)** aus einem ersten und einem zweiten Signal gebildet ist, die jeweils den Eingangssignalen **(1, 2)** zugeordnet sind, sowie zwei getrennte Kanäle für das erste und das zweite Signal vorgesehen sind.

12. Vorrichtung nach Anspruch 11, wobei jeder Kanal eine Reihenschaltung aus je einem über die Steuereinheit **(24)** individuell einstellbaren Verstärker **(7, 8),** einem Multiplexer **(9, 10),** einem Tiefpass-Filter **(13, 14),** einem Schwellwertschalter **(15, 16),** sowie einen Schalter **(17, 18)** umfasst.

13. Vorrichtung nach Anspruch 12, wobei zwischen Schwellwertschalter **(15, 16)** und Schalter **(17, 18)** eine elektrische Abzweigung für Kontrollsignale zur Steuereinheit **(24)** vorgesehen ist.

14. Vorrichtung nach einem der Ansprüche 10 bis 13, wobei die durch die Steuereinheit **(24)** kontrollierbaren Schalter **(17, 18)** die Ausblendung eines positiven oder eines negativen Ausgangssignals des Schwellwertschalters **(15, 16)** ermöglichen.

15. Vorrichtung nach Anspruch 14, wobei die Schalter **(17, 18)** über eine Failsafe-Logik verfügen, die eine simultane Unterdrückung beider Ausgangssignale der Schwellwertschalter **(15,16)** verhindern.

## Claims

1. Method for monitoring an electrical conductance value in an electrical conductor conducting current with a differential-mode voltage measuring bridge of a detector (31), wherein an input signal U_{Pos} (1) and an input signal U_{Neg} (2) are switched from two conductor sections connected in series against a common reference signal (3), wherein
a) the ratio of the differences in potential of U_{Pos} and U_{Neg} or vice-versa can be continually adjusted in each case to the reference signal between 0% and 100%, and therefore allows for any desired balancing of these differences in potential in relation to one another, and
b) the adjustment of the ratio is carried out by means of a double potentiometer balancing network (5), wherein the adjustment is digitally predetermined by a control unit (24), and the double potentiometer balancing network (5) generates a differential signal (6) on a nodal point (39).

2. Method according to claim 1, wherein the control unit (24) selects a positive or negative test voltage (26), and, in order to check on correct switching and/or connection between the input signals (1, 2, 3) and the double potentiometer balancing network (5), switches onto the nodal point (39).

3. Method according to claim 1 or 2, wherein the differential signal (6) is formed from a first and a second signal, which in each case are allocated to the input signals (1, 2) and are amplified, separated from one another, each by means of an amplifier (7, 8) which can be individually adjusted by the control unit (24), to two separate differential output signals.

4. Method according to claim 3, wherein the differential output signal of one of the amplifiers (7, 8), conducted via an anti-aliasing filter (23), is continuously scanned by an AD transformer (11) and displayed by the control unit (24) in a circulating memory unit (12) as ADC values, wherein, in the circulating memory unit, in each case in a memory word, and in addition to the ADC value, status information is secured which is simultaneously generated by the control unit (24).

5. Method according to one of claims 3 or 4, wherein, with a predetermined operating current direction in the conductor sections, a calculation is carried out of the effective voltage drop incurred in each case over each conductor section.

6. Method according to any one of claims 3 to 5, wherein the two differential output signals, in each case separately in one channel each, are
a) each conducted to a multiplexer (9, 10),
b) of which the output signals are each conducted to a low-pass filter (13, 14), which can be adjusted and disconnected independently of the control unit (24),
c) of which the output signals are then conducted in each case to bipolar threshold switches (15, 16), separate from the control unit (24) and digitally adjustable independently of one another,
d) of which the output signals are conducted in each case separately to a further switch (17, 18), influenced by the control unit (24), wherein either only the positive, only the negative, or both signals of the threshold switch (15 or 16) are conducted to the actual detector output (19, 20).

7. Method according to claim 6, wherein, from both channels, monitoring signals (21, 21', 22, 22') are picked up between the threshold switches (15, 16) and the switches (17, 18), and conducted back to the control unit (24).

8. Method according to claim 7, comprising a check of the multiplexers (9, 10) of the low-pass filters (13, 14) as well as of the threshold switches (15, 16), wherein
a) only one of the redundant channels present is interrupted at the multiplexer (9 or 10) and at the switch (17 or 18),
b) a test signal is selected by the control unit (24) at the multiplexer, which is conducted to the low-pass filter, instead of a differential output signal,
c) at least one monitoring signal (21, 21', 22, 22') is picked up from the channel between the threshold switch (15, 16) and switch (17, 18) and conducted back to the control unit (24), and
d) the monitoring signals are evaluated in the control unit (24).

9. Method according to claim 8, wherein, due to the adjustable double potentiometer balancing network (5), the amplifiers (7, 8) separately adjustable by the control unit (24) for each channel, and the conducting of the monitoring signals (21, 21', 22, 22') to the control unit (24), a calibration is made possible of the input signals (1, 2) in relation to the threshold switches (15, 16) which are to be set, wherein the calibration parameters are secured in a fixed-value memory (38).

10. Device for the indirect monitoring of an electrical conductance value in an electrical conductor, conducting current, with a differential voltage measuring bridge of a detector (31), wherein an input signal U_{Pos} (1) and an input signal U_{Neg} (2) are switched from two conductor sections connected in series against a common reference signal (3), wherein
a) the ratio of the differences in potential of U_{Pos} and U_{Neg} or vice-versa can be continually adjusted in each case to the reference signal between 0% and 100%, and therefore allows for any desired balancing of these differences in potential in relation to one another, and
b) a double potentiometer balancing network (5) is provided for generating a differential signal (6) for the adjustment of the ratio, wherein the adjustment is specified digitally by a control unit (24).

11. Device according to claim 10, wherein the differential signal (6) is formed from a first and a second signal, which in each case are allocated to the input signals (1, 2), and two separate channels are provided for the first and the second signal.

12. Device according to claim 11, wherein each channel comprises a circuit connected in series, in each case of an amplifier (7, 8), individually adjustable in each case via the control unit (24), a multiplexer (9, 10), a low-pass filter (13, 14), a threshold switch (15, 16), and a switch (17, 18).

13. Device according to claim 12, wherein, provided between the threshold switch (15, 16) and switch (17, 18), is an electrical branch for monitoring signals, branching to the control unit (24).

14. Device according to any one of claims 10 to 13, wherein the switches (17, 18) which can be controlled by the control unit (24) allow for the masking out of a positive or negative output signal of the threshold switch (15, 16).

15. Device according to claim 14, wherein the switches (17, 18) are provided with a failsafe logic, which prevents a simultaneous suppression of both output signals of the threshold switches (15, 16).

## Revendications

1. Procédé permettant de surveiller une conductance électrique dans un conducteur électrique dans lequel passe un courant, comprenant un pont de mesure de la tension différentielle d'un détecteur (31), un signal d'entrée U_{Pos} (1) et un signal d'entrée U_{Neg} (2) de deux segments conducteurs montés en série étant branchés à l'opposé d'un signal de référence commun (3),
procédé selon lequel :
a) le rapport respectif des différences de potentiel entre UPos et UNeg ou inversement et le signal de référence peut être réglé en continu entre 0% et 100%, et ainsi, un équilibrage quelconque de ces différences de potentiel l'une par rapport à l'autre est possible, et
b) le réglage du rapport est effectué par l'intermédiaire d'un réseau d'équilibrage à potentiomètres jumelés (5), le réglage étant prédéfini de manière numérique par une unité de commande (24), et le réseau d'équilibrage à potentiomètres jumelés (5) générant un signal différentiel (6) sur un point de noeud (39).

2. Procédé conforme à la revendication 1,
selon lequel l'unité de commande (24) sélectionne une tension de test positive ou négative (26), et, pour contrôler un branchement correct et/ou une liaison correcte entre les signaux d'entrée (1, 2, 3) et le réseau d'équilibrage à potentiomètres jumelés (5) se branche sur le point de noeud (39).

3. Procédé conforme à la revendication 1 ou 2,
selon lequel le signal différentiel (6) est formé d'un premier signal et d'un second signal qui sont respectivement associés aux signaux d'entrée (1, 2) et sont respectivement amplifiés séparément l'un de l'autre par un amplificateur respectif (7, 8) pouvant être réglé individuellement par l'unité de commande (24) pour obtenir deux signaux de sortie différentiels séparés.

4. Procédé conforme à la revendication 3,
selon lequel le signal de sortie différentiel de l'un des amplificateurs (7, 8) est détecté en continu par un convertisseur analogique / numérique AD (11) en étant transféré par l'intermédiaire d'un filtre anti-repliement (23) et est enregistré par l'intermédiaire de l'unité de commande (24) dans une mémoire circulante (12), dans la mémoire circulante étant en outre respectivement sauvegardées, dans un mot de mémoire, en plus de la valeur ADC des informations de statut simultanées générées par l'unité de commande (24).

5. Procédé conforme à l'une des revendications 3 et 4,
selon lequel, pour un sens prédéfini du courant de fonctionnement on effectue dans les segments conducteurs, un calcul de la chute de tension se présentant réellement sur chaque segment conducteur.

6. Procédé conforme à l'une des revendications 3 à 5,
selon lequel, les deux signaux de sortie différentiels sont respectivement, dans un canal respectif :
a) séparément transmis à un multiplexeur (9, 10),
b) dont les signaux de sortie sont respectivement transmis à un filtre passe-bas (13, 14) pouvant être réglé et déconnecté indépendamment par l'unité de commande (24),
c) dont les signaux de sortie sont ensuite respectivement transmis à des commutateurs à valeur de seuil bipolaires (15, 16) à réglage numérique séparé et indépendant par l'unité de commande (24),
d) dont les signaux de sortie sont respectivement transmis séparément à d'autres commutateurs (17, 18) sur lesquels intervient l'unité de commande (24),
seul le signal positif ou seul le signal négatif ou les deux signaux du commutateur à valeur de seuil (15 ou 16) étant transmi(s) à la sortie du détecteur propre (19, 20).

7. Procédé conforme à la revendication 6,
selon lequel par les deux canaux des signaux de contrôle (21, 21', 22, 22') sont saisis entre les commutateurs à valeur de seuil (15, 16) et les commutateurs (17, 18) et sont renvoyés à l'unité de commande (24).

8. Procédé conforme à la revendication 7,
comprenant un contrôle des multiplexeurs (9, 10), des filtres passe-bas (13, 14) ainsi que des commutateurs à valeur de seuil (15, 16), selon lequel,
a) seul l'un des canaux redondants est déconnecté au niveau du multiplexeur (9 ou 10) ou du commutateur (17 ou 18),
b) l'unité de commande (24) sélectionne, sur le multiplexeur, un signal de test, qui est ensuite transmis au filtre passe-bas à la place du signal de sortie de différentiel,
c) au moins un signal de contrôle (21, 21', 22, 22') provenant du canal est saisi entre le commutateur à valeur de seuil (15, 16) et le commutateur (17, 18) et est ensuite transmis à l'unité de commande (24), et
d) les signaux de contrôle sont exploités dans l'unité de commande (24).

9. Procédé conforme à la revendication 8,
selon lequel sur le fondement du réseau d'équilibrage à potentiomètres jumelés (5) réglable, de l'amplificateur (7, 8) pouvant être réglé séparément pour chaque canal par l'unité de commande (24), et du transfert des signaux de contrôle (21, 21', 22, 22') à l'unité de commande (24), un calibrage des signaux d'entrée (1, 2) à détecter par rapport aux commutateurs à valeur de seuil à régler (15, 16) est possible, les paramètres de calibrage étant sauvegardés dans une mémoire morte (38).

10. Dispositif permettant une surveillance indirecte d'une conductance électrique dans un conducteur électrique dans lequel passe un courant comportant un pont de mesure de la tension différentielle d'un détecteur (31), un signal d'entrée U_{Pos} (1) et un signal d'entrée U_{Neg} (2) de deux segments conducteurs montés en série étant branchés à l'opposé d'un signal de référence commun (3),
dispostif dans lequel
a) le rapport respectif des différences de potentiel entre U_{Pos} et U_{Neg} ou inversement et le signal de référence peut être réglé en continu entre 0% et 100%, et ainsi, un équilibrage quelconque de ces différences de potentiel l'une par rapport à l'autre est possible, et
b) il est prévu un réseau d'équilibrage à potentiomètres jumelés (5) pour générer un signal différentiel (6) permettant le réglage du rapport, le réglage étant prédéfini numériquement par une unité de commande (24).

11. Dispositif conforme à la revendication 10,
dans lequel le signal différentiel (6) est formé d'un premier signal et d'un second signal qui sont respectivement associés aux signaux d'entrée (1, 2), et deux canaux séparés sont prévus pour le premier signal et pour le second signal.

12. Dispositif conforme à la revendication 11,
dans lequel chaque canal comporte un montage en série respectif d'un amplificateur (7, 8) réglable individuellement par l'unité de commande (24), d'un multiplexeur (9, 10), d'un filtre passe-bas (13, 14), d'un commutateur à valeur de seuil (15, 16) et d'un commutateur (17, 18).

13. Dispositif conforme à la revendication 12,
dans lequel entre le commutateur à valeur de seuil (15, 16) et le commutateur (17, 18) est prévue une dérivation électrique permettant de transmettre des signaux de contrôle à l'unité de commande (24).

14. Dispositif conforme à l'une des revendications 10 à 13, dans lequel les commutateurs (17, 18) pouvant être contrôlés par l'unité de commande (24) permettent une suppression du signal de sortie positif ou du signal de sortie négatif du commutateur à valeur de seuil (15, 16).

15. Dispositif conforme à la revendication 14, dans lequel les commutateurs (17, 18) disposent d'une logique de sécurité positive qui empêche une suppression simultanée des deux signaux de sortie du commutateur à valeur de seuil (15, 16).
